# EUROPEAN PATENT APPLICATION

(11) **EP 4 654 395 A1**
(43) Date of publication of application: **26.11.2025**
(21) Application number: 25175547.6
(22) Date of filing: 09.05.2025
(51) Int. Cl.: H01R 13/405, B60L 53/16, H01R 13/52, H01R 13/53, H01R 13/66, H01R 13/502

(54) **SOCKET FOR AN EVSE**

(30) Priority: 24.05.2024 SE 2450564
(71) Applicant: Charge-Amps AB, 169 75 Solna (SE)
(72) Inventor: HELLSTRÖM, Jonas, 95441 Södra Sunderbyn (SE); HÖIJE, Krister, 11253 Stockholm (SE); LINDBLOM, Alexander, 97593 Luleå (SE); AUSTAD, Filip, 18761 Täby (SE)
(74) Representative: Brann AB

(57) **Abstract**

The disclosure relates to a socket 100 configured to receive a charging plug for an electrical vehicle, wherein the socket conforms to the European Electrotechnical Commission's conductive charging interface standard for electric vehicles, IEC 62196-1 and IEC 62196-2 standard, the socket comprising: a plurality of connector elements (101-107) arranged in a pattern conforming to the standard, wherein the connector elements (101-107) are elongated, wherein each connector element have a first end configured to receive a corresponding connector pin and a second end configured to electrically connect the connector element, a base unit (110) molded to the plurality of connector elements, wherein the base unit (110) is arranged between the first ends and the second ends of the plurality of connector elements (101-107) having a first side facing the first ends and a second side facing the second ends, a first part (610) of a housing configured to be in mechanical contact with the first side of the base unit (110), and, a second part (640) of the housing.

## Description

### TECHNICAL FIELD

The present invention relates to an electrical socket or outlet for a charger for electric vehicles. In particular, a socket that conforms to the European Electrotechnical Commission's conductive charging interface standard for electric vehicles, IEC 62196-1 and IEC 62196-2.

### BACKGROUND

An electric vehicle supply equipment, EVSE, is typically an apparatus for supplying electric energy for the recharging of a vehicle, such as plug-in electric vehicles, e.g., electric cars and plug-in hybrids.

The EVSE is typically provided with a socket configured to connect to a vehicle by means of a charging cable. The interface at the charging cable is called EV Plug (IEC 62196-1 and IEC 62196-2). The socket assembly typically consists of a socket outlet interface area defined by standard IEC 62196-1 and IEC 62196-2, contact sleeves for phase, neutral, earth and two signal sleeves.

A drawback with conventional sockets is that they typically comprise many different parts, that adds complexity and costs when assembling the EVSE. Also, if mounted incorrectly, the different parts can cause malfunction or accidents. Also, since many parts need to be assembled, it is easy to forget a part, e.g., a seal.

A further challenge with conventional sockets is fatigue. This is due to the fact that each time an EV Plug is inserted or withdrawn from the Socket or outlet, the contact sleeves or elements and their connection to conductors are subject to big mechanical forces that can lead to cracks and malfunction during the product's lifetime. The insertion force of the plug can be as high as up to 100 N pushing on the contact elements. Movement in the signal or power pins will cause fatigue over time, e.g. in an electrical connection of the contact sleeves or elements to the PCB.

In one example, flexing and cycling movement in a PCB of the socket due to insertion/removal forces might cause tension and or risk for cracks in connections which result in malfunction or temperature increase. Parts of the socket that are soldered, riveted, screwed, punched or press-fitted needs to be protected from forces applied directly due to engagement or disengagement of an EV plug, and they also need protection from intentional mechanical vandalism.

The standards IEC 62196-1 and IEC 62196-2 demands that the socket of the EV-charger to handle at least 10.000 mating cycles between the plug and the socket. A mating cycle consists of one engagement and a disengagement between socket and EV plug. It is preferred that the socket can handle well above 10.000 mating cycles due to sustainability.

A further challenge is to achieve sufficient creepage and clearance distance on the PCB as well as to achieve adequate area of conductor cross section on the PCB. This is due to the fact that the standards IEC 62196-1 and IEC 62196-2 limits the design freedom at the power pins and signal pins, which are located at fixed positions in a fixed pattern. The size of the diameter of the power and signal sleeves in combination with the electrical connection determines the strength of the connection. E.g., a cross section area of the solder seam or cross section area of press fittings.

Thus, there is a need for an improved socket for an EVSE.

### OBJECTS OF THE INVENTION

An objective of embodiments of the present invention is to provide a solution which mitigates or solves the drawbacks and problems described above.

### SUMMARY OF THE INVENTION

The above and further objectives are achieved by the subject matter described herein. Further advantageous implementation forms of the invention are further defined herein. The invention is set out in the appended claims. The scope of the invention is defined by the claims, which are incorporated into this section by reference.

According to a first aspect of the invention the object of the invention is achieved by a socket configured to receive a charging plug for an electrical vehicle, wherein the socket conforms to the European Electrotechnical Commission's conductive charging interface standard for electric vehicles, IEC 62196-1 and IEC 62196-2 standard, the socket comprising: a plurality of connector elements arranged in a pattern conforming to the standard, wherein the connector elements are elongated, wherein each connector element have a first end configured to receive a corresponding connector pin and a second end configured to electrically connect the connector element, a base unit molded to the plurality of connector elements, wherein the base unit is arranged between the first ends and the second ends of the plurality of connector elements having a first side facing the first ends and a second side facing the second ends, a first part of a housing configured to be in mechanical contact with the first side of the base unit, and, a second part of the housing.

In one embodiment according to the first aspect, the base unit is provided with one or more reinforcement members, wherein the one or more reinforcement members are arranged in mechanical contact to the second part and/or arranged between connector elements to improve electric isolation.

In one embodiment according to the first aspect, the base unit is provided with one or more wing elements configured to connect the base unit to the second part of the housing.

In one embodiment according to the first aspect, the wing elements are extending out from the base unit along a plane intersecting the central axes of the plurality of connector elements.

In one embodiment according to the first aspect, each of the plurality of connector elements is provided with a rotational blocking element in a section of the connector element molded to the base unit, wherein the rotational blocking element is configured to prevent rotation of the connector element around its central axis.

In one embodiment according to the first aspect, the rotational blocking element comprises a recess.

In one embodiment according to the first aspect, each of the plurality of connector elements is provided with at least one anti-sliding element.

In one embodiment according to the first aspect, the base unit is provided with one or more support elements, wherein the support elements are arranged to be in contact with the first part of the housing.

In one embodiment according to the first aspect, the socket is further comprising: a sealing member arranged between the base unit and the first part housing, the sealing member being configured to form at least a water-resistant seal between contacting surfaces of the base unit and the first part of the housing.

In one embodiment the sealing member is a flat gasket. In one embodiment, the sealing member is a labyrinth sealing.

In one embodiment, the socket further comprises a printed circuit board, PCB, wherein each of the second ends of the plurality of connector elements is configured to electrically connect the connector element to a cable or wire, wherein the cable or wire is electrically connected to the PCB.

In one embodiment, the socket further comprises a printed circuit board, PCB, wherein each of the second ends of the plurality of connector elements is provided with a solder, rivet, pressfit or screwing section to electrically connect the connector element to thePCB.

In one embodiment according to the first aspect, the socket further comprises a printed circuit board, PCB.

In one embodiment according to the first aspect, wherein the housing further comprises a second part configured to form a support for the base unit.

In one embodiment according to the first aspect, the second part forms a support by: being arranged in mechanical contact with the base unit, or forms a support via a bracket by being arranged in mechanical contact with the bracket, and the bracket is further arranged in mechanical contact with the base unit.

Further aspects of the disclosure are shown in the attached drawings.

### BRIEF DESCRIPTION OF THE DRAWINGS

It should be appreciated that like reference numerals are used to identify like elements illustrated in one or more of the figures.
**Fig. 1A-B** shows details of a socket 10 according to embodiments of the present disclosure.
**Fig. 2** shows reinforcement members according to one or more embodiments of the present disclosure.
**Fig. 3** illustrates wing elements according to one or more embodiments of the present disclosure.
**Fig. 4** illustrates support elements according to one or more embodiments of the present disclosure.
**Fig. 5A-B** illustrates rotational blocking elements and anti-sliding elements according to one or more embodiments of the present disclosure.
**Fig. 6** shows an exploded view of a socket according to one or more embodiments of the present disclosure.
**Fig. 7** shows a labyrinth sealing according to one or more embodiments of the present disclosure.
**Fig. 8A-B** shows embodiments of the of the second ends of the plurality of connector elements according to one or more embodiments of the present disclosure.
**Fig. 9** shows an embodiment of fastening elements according to one or more embodiments of the present disclosure.

A more complete understanding of embodiments of the invention will be afforded to those skilled in the art, as well as a realization of additional advantages thereof, by a consideration of the following detailed description of one or more embodiments.

### DETAILED DESCRIPTION

An "or" in this description and the corresponding claims is to be understood as a mathematical OR which covers "and" and "or", and is not to be understand as an XOR (exclusive OR). The indefinite article "a" in this disclosure and claims is not limited to "one" and can also be understood as "one or more", i.e., plural.

In the present disclosure the term "EVSE" denotes an electric vehicle charging station or an apparatus for supplying electric energy to plug-in electric vehicles.

The present disclosure relates to a socket in an EVSE configured to receive a charging cable, e.g., for an electric vehicle.

The present disclosure addresses problems arising from the mechanical stress of repeatedly inserting and removing a corresponding plug from the socket as well as reducing the complexity of assembling the socket and/or assembling an EVSE.

The present disclosure solves these problems by molding signal and power pins or elements in a single step to the base unit, which typically is made from plastic materials. The present disclosure simultaneously provides a linear and rotational lock of contact elements in combination with the adhesion to the plastic, which creates a strong mechanical fixation.

The forces originating from engagement and disengagement of a plug with the socket are mainly axial and parallel to the connector elements 101-107 but also inflicts a small portion of rotational force. The forces are transferred from the plugs connector pins to the connector elements 101-107 in the socket.

The present further disclosure distributes forces from the connector elements to the base unit, and from the base unit to the housing. As mentioned above, the connector elements are molded to the base unit and are optionally equipped with force transferring features, e.g., a rotational blocking element 510.

The mold creates a strong bond between the base unit 110 and the metal connector elements. To further distribute the forces from the base unit the base unit is optionally equipped with reinforcement members, wing elements and support members. All of them integrated to the base unit. The reinforcement members 210, 220 may distribute forces to the rear housing 640 during engagement of the plug. The wing elements 310, 320, will aid in positioning of the socket by resting on a support and/or a bracket on the rear housing 640 as well as distributing forces to rear housing during disengagement of the plug. The support members 410, 420, 430 will distribute forces from the base unit to the front housing 610 during both engagement and disengagement of the plug. Additionally, a compressible sealing member or labyrinth sealing 620 may be placed between the base unit and the front housing. The sealing functionality can handle small displacements in axial direction of the connector elements that will arise due to yielding of the socket and the front and rear housing during engagement and disengagement of the plug. The sealing member or labyrinth seal is necessary to obtain ingress protection of at least IP44 for outside use that is a requirement in standards IEC 62196-1 and 62196-2.

The increased strength and/or transfer of forces means less movement of connector elements, such as signal and power pins, and therefore reduces fatigue as well as direct mechanical forces into any electric connections, e.g., an electric connection of connector elements to a printed circuit board, PCB. This reduces risks for cracks in parts of the socket, and also prevents the risk of screws or rivets coming loose etc.

As mentioned, present disclosure conveys the forces originating from engagement and disengagement of a plug with the socket. The forces are e.g., transferred from the connector elements into the base unit and/or housing of the socket and further distributed to a wall on which the charger/EVSE is mounted. This creates a solid and stable interface for the cable plug to connect into. The forces created during engagement and disengagement of the plug will therefore be handled by the charger/EVSE shell rather than by the connector elements.

Further the optional reinforcements members will also aid in separating the conductors of the PCB by providing more space allowing increasing of the creepage distance thus providing the possibility to have a larger diameter of the signal and power conductors at places of connection to the PCB.

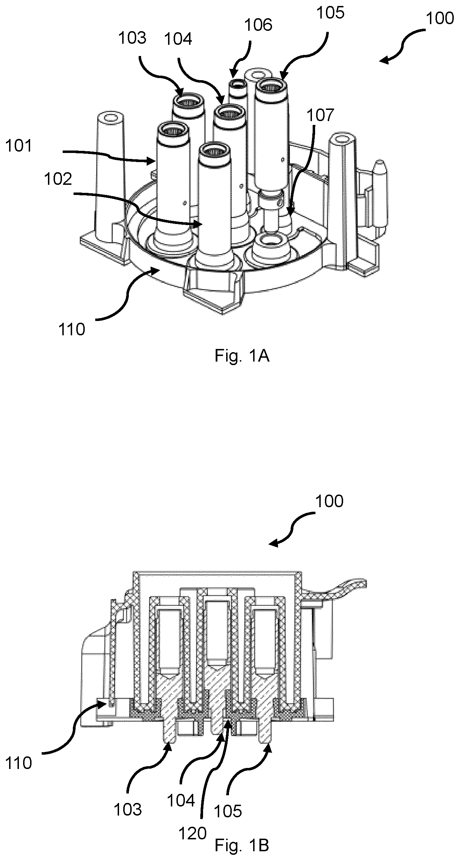

**Fig. 1A-B** shows details of a socket 100 according to embodiments of the present disclosure.

**Fig. 1A** shows a perspective view of the socket 100.

The socket 100 is configured to receive a charging plug for an electrical vehicle EV. The socket is configured to be installed in an EVSE. The plug is typically mounted on a charging cable connecting the EV to the socket of the EVSE. The socket 100 conforms to the European Electrotechnical Commission's conductive charging interface standard for electric vehicles, IEC 62196-1, and IEC 62196-2 standard.

The socket 100 comprises a plurality of connector elements 101-107 arranged in a pattern conforming to the standard. The plurality of connector elements 101-107, e.g., connector pins or sleeves, comprises connector elements configured to provide electrical energy and connector elements configured to provide signaling.

The connector elements 101-107, e.g., sleeves, are elongated, e.g., having a cylindrical shape. Each connector element has a first end configured to receive a corresponding connector element, such as a pin of the plug, and a second end configured to electrically connect the connector element, e.g., to a PCB or to individual cables or wire conductors.

The socket 100 further comprises a base unit 110 molded to the plurality of connector elements. The base unit 110 is typically molded using plastic materials. The base unit 110 is arranged between the first ends and the second ends of the plurality of connector elements 101-107. The base unit 110 have a first side facing the first ends and a second side facing the second ends.

For illustrative purposes, one of the connector elements 105 is shown as extracted from the base unit 110.

**Fig. 1B** shows a side view of the socket 100. In Fig. 1B it can be seen how the second ends of the plurality of connector elements 101-107 protrudes through the second side of the base unit 110.

By molding the base unit 110 to the plurality of connector elements 101-107, a strong mechanical fixation is created that can absorb the forces occurring along or around central axes of the connector elements during insertion insertion/removal of the charging plug.

In embodiments, all, or a selection of the plurality of connector elements 101-107 are further provided with an anti-sliding element to further improve transfer of forces from the connector elements 101-107 to the base unit 110.

The anti-sliding element comprises at least one diameter transition or perimeter change of the connector element adjacent to, or at the base unit 110.

In the example shown in Fig. 1A, the anti-sliding element is configured in the form of a flange, but any suitable shape is envisioned without departing from the present disclosure.

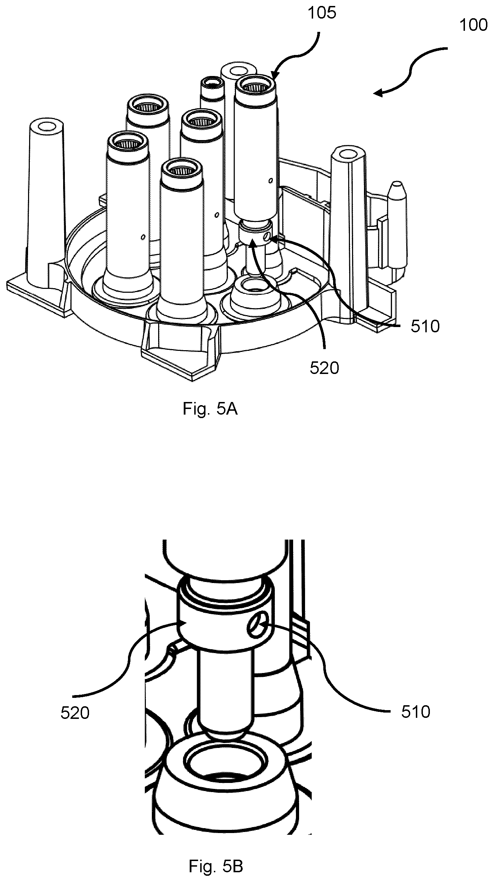

In embodiments, all, or a selection of the plurality of connector elements 101-107 are further provided with rotational blocking element 510, further described in relation to Fig. 5.

In other words, the connector elements 101-107 can be configured with features that prevent or reduce axial movement along central axes and rotational movement around the central axes.

To further reduce axial movement along central axes of the connector elements 101-107, the present disclosure provides reinforcement members 210 , 220 on the base unit 110.

In embodiments, the base unit 110 is provided with a plurality of recesses 130 forming one or more cavities 120 (shown as white hollow regions), wherein the cavities are formed between a PCB 630 and the base unit 110 and enclosing sections of the connector elements 101-107.

The cavities will create a depot/buffer zone to let excessive solder and air flow inside during the solder process to create a proper bond between the PCB and the connector elements 101-107, e.g., power pins and/or signal pins, second ends. Without the recesses, an obstacle might be created for the airflow which results in poor filling of solder connecting the PCB to the power and/or signal pins. Poor filling results in poor solder joints which will reduce the strength and resistance to fatigue. The cavities might be represented in other ways than directly described, e.g., as a hole protruding the base unit and enclosing the connector elements 101-107. I.e., in contact or linked to a power pins or signal pins.

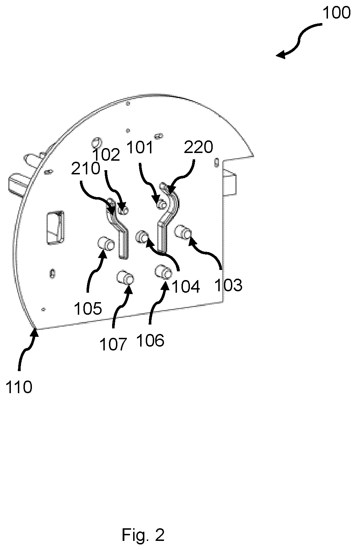

**Fig. 2** shows reinforcement members according to one or more embodiments of the present disclosure. Fig. 2 shows a view of the second side of the base unit 110 with connector elements 101-107 protruding from the surface of the second side.

In this embodiment, the base unit 110 of the socket 100 is further provided with one or more reinforcement members 210, 220 on the second side.

In particular, in embodiments where the connector elements 101-107 are electrically connected via a PCB, the available space is limited. The available space must be shared between electrical coupling members, such as solder seam, electrically connecting the connector elements to the PCB and mechanical fastening members, e.g., press fittings, coupling the connector elements to the PCB and/or other parts of the socket.

This presents a challenge when considering electric design targets, such as achieving sufficient creepage and clearance distance on the PCB and/or adequate area of conductor cross section on the PCB to cope with electrical effect transferred via the socket.

This is at least in part due to the fact that the standards IEC 62196-1 and IEC 62196-2 limits the design freedom at the power pins and signal pins, which are located at fixed positions and in a fixed pattern.

The present solution solves this challenge by physically separating the electrical coupling members by introducing reinforcement members 210, 220 which improves electric isolation.

As mentioned previously, the second side of the base unit 110 is facing the second end of the connector elements 101-107.

According to one aspect of the disclosure, the one or more reinforcement members 210, 220 are configured to absorb forces acting along central axes of the plurality of connector elements 101-107.

In one example, a rear/second part 640 of the housing form a support for the base unit 110 via the reinforcement members 210, 220. In other words, the reinforcement members 210, 220 transfer axial forces from the connector elements 101-107 to the second part 640 of the housing by being arranged in mechanical contact to the rear/second part 640 of the housing.

In one further example, the one or more reinforcement members 210, 220 are configured to Improve electric isolation between conductors, e.g., conductors of a printed circuit board, PCB.

In embodiments, the one or more reinforcement members 210, 220 are arranged in mechanical contact to the second part 640 and/or arranged between connector elements to improve electric isolation In other words, the optional reinforcements members 210, 220 will also aid in separating the conductors of the PCB by providing more space allowing increasing of the creepage distance thus providing the possibility to have a larger diameter of the signal and power conductors at places of connection between connector elements 101-107 and the PCB.

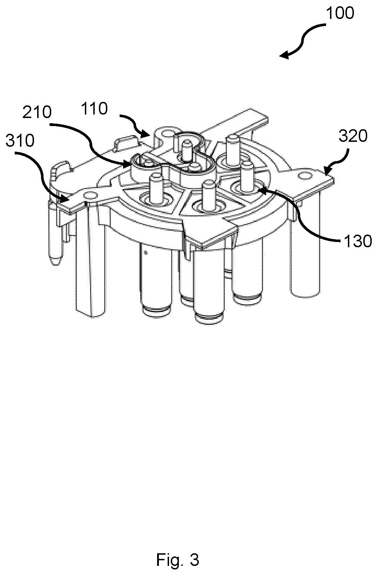

**Fig. 3** illustrates wing elements 310, 320 according to one or more embodiments of the present disclosure.

The wing elements 310, 320 are configured with at least one surface placed in mechanical contact with the second part/rear part of housing 640 or a bracket mounted to the housing 640.

The wing elements 310, 320, will aid in positioning of the base unit by resting on a support or a bracket on the rear housing 640 as well as distributing forces from connector elements to the rear housing 640 during disengagement of the plug.

In embodiments, the base unit 110 of the socket 100 is provided with one or more wing elements 310, 320 configured to connect to a housing 640. In one embodiment, the wing elements are extending out from the base unit 110 along a plane intersecting the central axes of the plurality of connector elements 101-107. The plane may e.g., be arranged perpendicular to the central axes of the plurality of connector elements 101-107 or at an angle to the central axes of the plurality of connector elements 101-107.

In particular, the one or more wing elements 310, 320 are configured to mechanically connect the base unit 110 to the second part of the housing 640.

By providing the base unit 110 with wing elements 310, 320 the base unit can be both positioned relative to, and mechanically connected to the rear housing 640. The base unit provided with wing elements 310, 320 may be slid in place towards corresponding cavities or supportive geometry on the rear housing 640 to create mechanical rest.

In other words, the wing elements 310, 320 both reduces complexity when assembling the socket 100 and aids in transferring forces from connector elements 101-107 to the rear housing 640.

The wing elements will mainly absorb and distribute pulling forces in axial direction of the connector elements 101-107 to the housing 640 when engaging/disengaging the plug.

Fig. 3 also show an alternative embodiment of a reinforcement member 210.

In embodiments, the base unit 110 is provided with a plurality of recesses 130 forming one or more cavities 120, wherein the cavities are formed between a PCB 630 and the base unit 110 and enclosing sections of the connector elements 101-107.

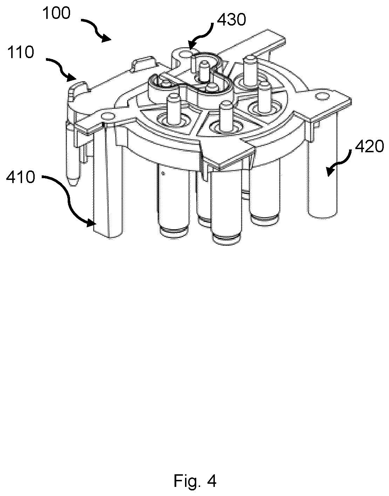

**Fig. 4** illustrates support elements 410, 420, 430 according to one or more embodiments of the present disclosure.

In embodiments, the base unit 110 is in contact with a front/first part of the housing 610. The front part being configured to face or receive the plug to be inserted into the socket. To further reduce complexity when assembling the socket, support elements 410, 420, 430 are integrated into the base unit.

The base unit 110 of the socket 100 is provided with one or more support elements 410, 420, 430. The support elements are arranged somewhere between the second end of the plurality of connector elements 101-107 and the housing 610. The one or more support elements 410, 420, 430 are arranged to be in contact/mechanical contact with the front/first part of the housing 610.

In one example, the support elements 410, 420, 430 are extending from the wing elements, described further in relation to Fig. 3. The support elements 410, 420, 430 are effectively extending from the first side facing the first ends of the plurality of connector elements 101-106 to the part of the housing 610. In other words, the support elements 410, 420, 430 mechanically connect the base unit 110 to the front/first part of the housing 610. Fastening elements, such as e.g. screws or snaps-fits, may then lock the front/first part 610 of the housing to the base unit 110.

In other words, the support elements 410, 420, 430 transfer axial and radial forces from the connector elements 101-107 to the front/first part 610 of the housing.

**Fig. 5A** illustrates rotational blocking elements 510 and anti-sliding elements 520 according to one or more embodiments of the present disclosure. For illustrative purposes, one of the connector elements 105 is shown as extracted from the base unit 110 in Fig. 5.

As further described in relation to Fig 1A-B, the strong mechanical fixation created by molding the base unit 110 to the plurality of connector elements 101-107 and further improved by addition of optional rotational blocking elements 510 and/or anti-sliding elements 520.

The rotational blocking elements 510 assists in absorbing rotational forces around central axes of the connector elements 101-107.

In embodiments, all, or a selection of the plurality of connector elements 101-107 are further provided with one or more rotational blocking elements 510 in a section of the connector element molded to the base unit 110. Each rotational blocking element 510 is configured to prevent rotation of the connector element around its central axis.

In one embodiment, the rotational blocking element 510 comprises a cavity or recess. The recess allows plastic to fill the recess when the base unit is directly molded to the plurality of connector elements 101-107.

The rotational blocking element 510 can absorb the rotational forces occurring around central axes of the connector elements during insertion insertion/removal of the charging plug.

In embodiments, all, or a selection of the plurality of connector elements 101-107 are further provided with anti-sliding elements 520 to further improve transfer of forces from the connector elements 101-107 to the base unit 110. In the example shown in Fig. 1A, the anti-sliding element is configured in the form of a flange, but any suitable shape is envisioned without departing from the present disclosure, e.g., a diameter transition or change in perimeter shape of the connector elements.

The anti-sliding element 520 can absorb and/or transfer the forces occurring along central axes of the connector elements during insertion insertion/removal of the charging plug.

In other words, the rotational blocking element 510 and/or anti-sliding elements 520 transfer axial and radial forces from the connector elements 101-107 to the housing 610, 640.

**Fig. 5B** provides a detailed view of the rotational blocking elements 510 and anti-sliding elements 520 according to one or more embodiments of the present disclosure.

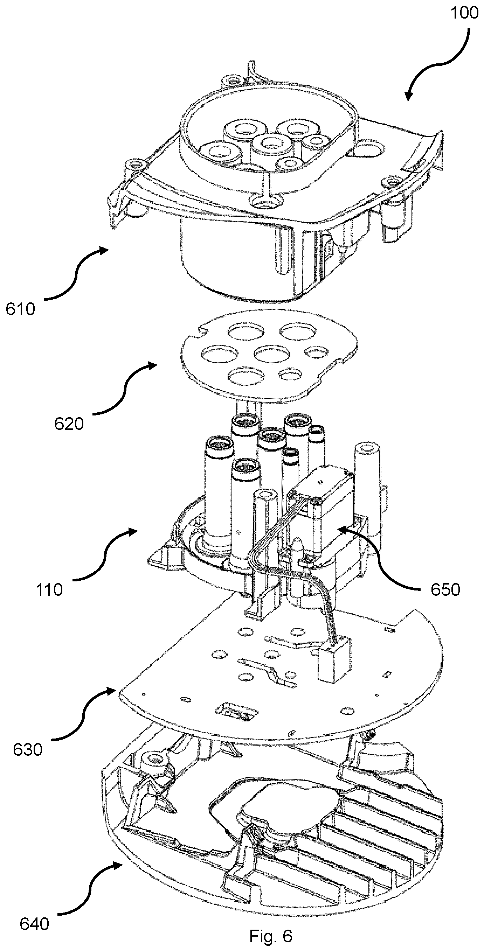

**Fig. 6** shows an exploded view of a socket 100 according to one or more embodiments of the present disclosure.

In this particular example, the housing of the socket 100 comprises a first part or a front part of the housing 610. The first part 610 may be configured to face or receive the plug to be inserted into the socket. The housing of the socket 100 further comprises a second part or rear part 640 of the housing that form a support for the base unit 110 as well as support for the optional wing elements 310, 320.

In one example, the second part 640 may form a support by being arranged in mechanical contact with the base unit 110. E.g., in mechanical contact with the first or second side of the base unit 110.

In a further example, the second part 640 may form a support by being arranged in mechanical contact with a bracket, and the bracket is further arranged in mechanical contact with the base unit 110.

The socket 100 further comprises the base unit 110.

Optionally, the base unit 110 further comprises a locking arrangement 650 configured to lock the socket 100 to an inserted plug. In one non-limiting example, the locking arrangement 650 is a servo motor, stepping motor or an actuator and a linkage that is capable to lock a plug in a position where it is inserted into the socket.

The first part 610 of the housing may e.g., be arranged to be in contact with the base unit 110 when the socket is assembled via the support elements 410, 420, 430, further described in relation to Fig. 4.

The second part 640 of the housing may e.g., be arranged to be in contact with the base unit 110 when the socket is assembled via the reinforcement members 210, 220 and/or the wing elements 310, 320. In other words, the reinforcement members 210, 220 and/or the wing elements 310, 320 may in some embodiments transfer axial/rotational forces from the connector elements 101-106 to the second part 640 of the housing of the socket.

Between the first part 610 of the housing and the base unit 110, a sealing member 620 is arranged. The sealing member 620 is configured to form at least a water-resistant seal between contacting surfaces of the base unit 110 and the housing 610.

In one embodiment, the sealing member 620 is a flat compressible gasket.

In one embodiment, the sealing member 620 is over molded with a compressible material to the first side of the base unit to reduce the required number of parts of the socket 100.

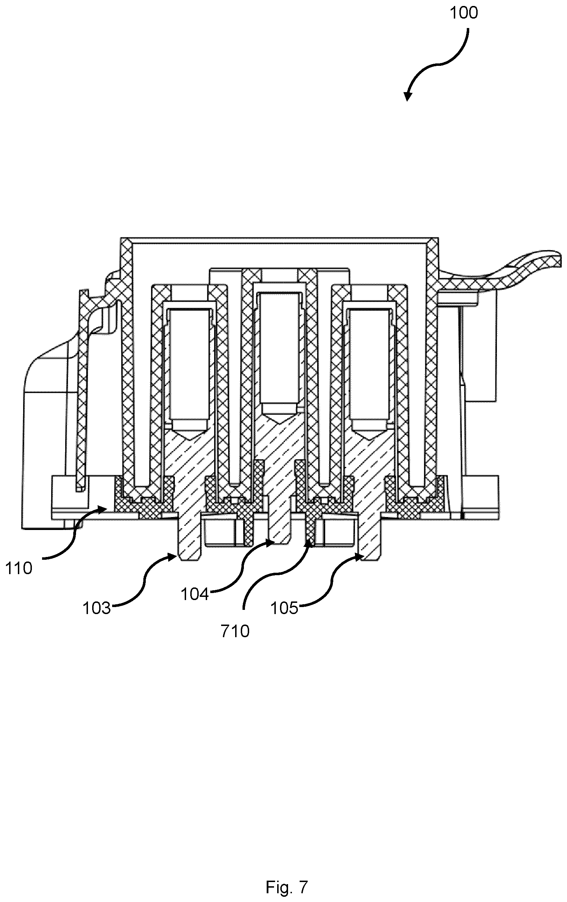

In one further embodiment, the sealing member 620 is a labyrinth sealing, further described in relation to Fig. 7.

In one embodiment, the socket 100 further comprises a PCB 630. The PCB 630 is configured to electrically connect the plurality of connector elements 101-107, e.g., to power and signal lines of an EVSE, and/or to electrically connect the locking arrangement 650.

In one further embodiment, the socket 100 further comprises individual or grouped cables or wires that are configured to electrically connect the plurality of connector elements 101-107, e.g., to power and signal lines of an EVSE, and/or to electrically connect the locking arrangement 650.

In the example shown in Fig. 6, the socket 100 further comprises fastening elements such as screws, snap-fits, rivets or press fittings (not shown).

When tightened, the fastening elements forces the first part 610 of the housing to be in contact directly to the base unit 110 or via the sealing member 620. The contact between the base unit, the sealing member 620 and the first part 610 of the housing form at least a water-resistant seal between contacting surfaces of the base unit 110 and the housing 610.

**Fig. 7** shows a labyrinth sealing according to one or more embodiments of the present disclosure.

A labyrinth seal is a type of mechanical seal that provides a tortuous path to help prevent leakage between surfaces. A labyrinth seal may be composed of many grooves that press tightly to a surface, so that any fluid has to pass through a long and difficult path to pass through.

An example of labyrinth sealing 710 is shown in Fig 7.

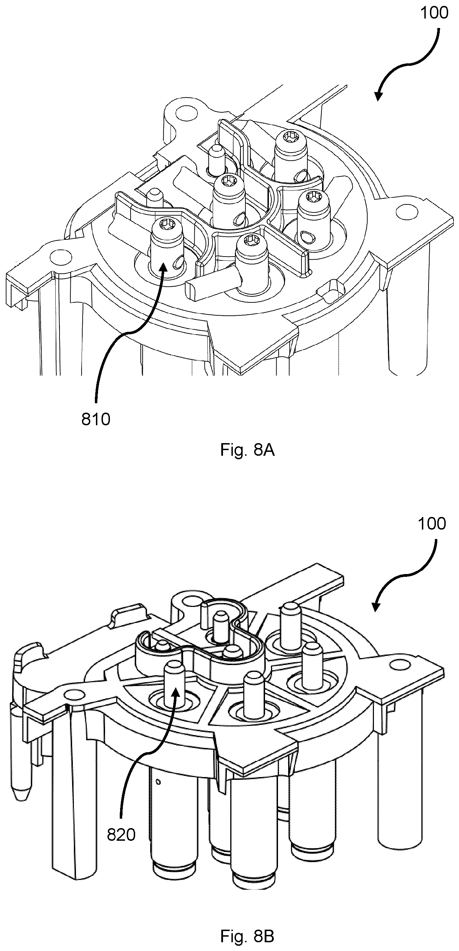

**Fig. 8A-B** shows embodiments of the of the second ends of the plurality of connector elements according to one or more embodiments of the present disclosure.

**Fig. 8A** shows an embodiment of the of the second ends of the plurality of connector elements according to one or more embodiments of the present disclosure.

In this embodiment, each of the second ends of the plurality of connector elements 101-107 of the socket 100 is configured to electrically connect the connector element to a cable or wire using a mechanical coupling 810, e.g., a screw coupling, rivet, crimping, welding or solder.

**Fig. 8B** shows a further embodiment of the of the second ends of the plurality of connector elements according to one or more embodiments of the present disclosure.

In this embodiment, each of the second ends of the plurality of connector elements 101-107 of the socket 100 is provided with a soldering coupling 820 configured to electrically connect the connector element to a printed circuit board 630 using soldering.

It is understood that any suitable electrical coupling method, e.g., press-fit, screw coupling or riveting, may be used without departing from the present disclosure.

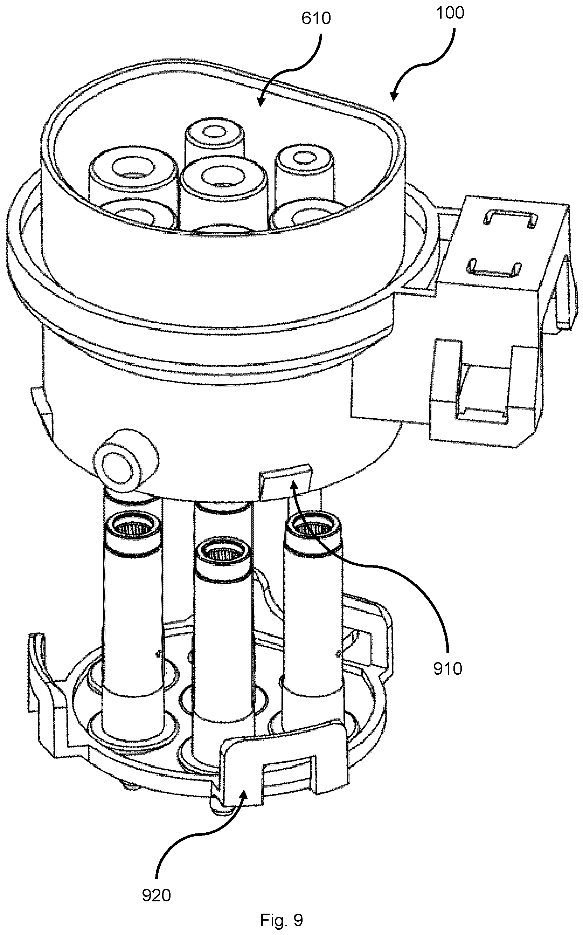

**Fig. 9** shows an embodiment of support elements acting as integrated snap-fits according to one or more embodiments of the present disclosure.

As further described in relation to Fig. 6. The base unit 110 may further comprise support elements acting as fastening elements configured to force parts the front housing 610 to the base unit 110. In other words, to hold two or more parts together such that contacting surfaces of the respective parts remain in contact.

In some embodiments, the support elements are pairs of a hook 910 and a clip 920 where the clip is configured to lock to the hook when placed in a locking position.

Referring back to Fig. 4, the fastening elements 910-920 in this embodiment include features for both support elements 410-430 and fastening elements, i.e. holding and securing the base unit to the front housing 610.

In the example shown in Fig. 9, the base unit 110 is moved in a direction parallel to the axes of the plurality of connector elements 101-107 towards the first part 610 of the housing until the base unit are in in contact with the first part 610 of the housing, where a locking position is reached and the clip 920 locks onto the hook 910.

Finally, it should be understood that the invention is not limited to the embodiments described above, but also relates to and incorporates all embodiments within the scope of the appended independent claims.

## Claims

1. A socket (100) configured to receive a charging plug for an electrical vehicle, wherein the socket conforms to the European Electrotechnical Commission's conductive charging interface standard for electric vehicles, IEC 62196-1 and IEC 62196-2 standard, the socket comprising:
a plurality of connector elements (101-107) arranged in a pattern conforming to the standard, wherein the connector elements (101-107) are elongated, wherein each connector element have a first end configured to receive a corresponding connector pin and a second end configured to electrically connect the connector element,
a base unit (110) molded to the plurality of connector elements, wherein the base unit (110) is arranged between the first ends and the second ends of the plurality of connector elements (101-107), the base unit having a first side facing the first ends and a second side facing the second ends,
a first part (610) of a housing configured to be in mechanical contact with the first side of the base unit (110), and
a second part (640) of the housing.

2. The socket according to claim 1, wherein the base unit (110) is provided with one or more reinforcement members (210, 220), wherein the one or more reinforcement members are (210, 220) arranged in mechanical contact to the second part (640) and/or arranged between connector elements to improve electric isolation.

3. The socket according to any of the preceding claims, wherein the base unit (110) is provided with one or more wing elements (310, 320) configured to connect the base unit (110) to the second part of the housing (640), wherein the wing elements are extending out from the base unit (110) along a plane intersecting the central axes of the plurality of connector elements (101-107).

4. The socket according to any of the preceding claims, wherein each of the plurality of connector elements (101-107) is provided with a rotational blocking element (510) in a section of the connector element molded to the base unit (110), wherein the rotational blocking element (510) is configured to prevent rotation of the connector element around its central axis.

5. The socket according to claim 4, wherein the rotational blocking element (510) comprises a recess.

6. The socket according to any of the preceding claims, wherein each of the plurality of connector elements (101-107) is provided with at least one anti-sliding element.

7. The socket according to claim 1, wherein the base unit (110) is provided with one or more support elements (410, 420, 430), wherein the support elements (410, 420, 430) are arranged to be in contact with the first part (610) of the housing.

8. The socket according to any of the preceding claims, further comprising:
a sealing member (620) arranged between the base unit (110) and the first part (610) housing, the sealing member (620) being configured to form at least a water-resistant seal between contacting surfaces of the base unit (110) and the first part of the housing (610).

9. The socket according to claim 8, wherein the sealing member (620) is a flat gasket.

10. The socket according to claim 8, wherein the sealing member (620) is a labyrinth sealing.

11. The socket according to any of the preceding claims, wherein the socket further comprises a printed circuit board, PCB, (630), wherein each of the second ends of the plurality of connector elements (101-107) is configured to electrically connect the connector element to a cable or wire, wherein the cable or wire is electrically connected to the PCB (630).

12. The socket according to any of the preceding claims, wherein the socket further comprises a printed circuit board, PCB, (630), wherein each of the second ends of the plurality of connector elements (101-107) is provided with a solder, rivet, press-fit or screw section to electrically connect the connector element to the PCB (630).

13. The socket according to any of the preceding claims, wherein the housing further comprises a second part (640) configured to form a support for the base unit (110).

14. The socket according to claim 13, wherein the second part (640) forms a support by: being arranged in mechanical contact with the base unit (110), or
forms a support via a bracket by being arranged in mechanical contact with the bracket, and the bracket is further arranged in mechanical contact with the base unit (110).

15. The socket according to any of claims 11-12, wherein the base unit (110) is provided with a plurality of recesses (130) forming one or more cavities (120), wherein the cavities are formed between the PCB (630) and the base unit (110) and enclosing sections of the connector elements (101-107).
